Europäisches Patentamt

European Patent Office

Office européen des brevets

(19)

(11) Publication number: **0 206 462 B1**

## EUROPEAN PATENT SPECIFICATION

(45) Date of publication of patent specification: **23.10.91**  (51) Int. Cl.⁵: **H03K 19/096, H03K 19/173**

(21) Application number: **86302860.1**

(22) Date of filing: **16.04.86**

(54) Method of precharging and precharge circuit for dynamic cascode voltage switch logic.

(30) Priority: **23.04.85 US 726211**

(43) Date of publication of application:
**30.12.86 Bulletin 86/52**

(45) Publication of the grant of the patent:
**23.10.91 Bulletin 91/43**

(84) Designated Contracting States:
**DE FR GB**

(56) References cited:
**US-A- 3 739 193**
**US-A- 4 250 406**

**IEEE INTERNATIONAL SOLID-STATE CIR-
CUITS CONFERENCE, conf. 31, San Fran-
cisco, 22nd-24th February 1984, vol. 27,
pages 16-17, IEEE, New York, US; L.G. HELL-
ER et al.: "Cascode voltage switch logic: A
differential CMOS logic family"**

**IBM TECHNICAL DISCLOSURE BULLETIN, vol.
27, no. 11, April 1985, pages 6789-6790, New
York, US; "Single-ended cascode voltage
switch logic circuit"**

**IBM TECHNICAL DISCLOSURE BULLETIN, vol.
27, no. 10B, March 1985, pages 6023-6024,**

**New York, US; "Receiver for clocked or
pseudo-clocked cascode voltage switch log-
ic"**

**IEEE Journal of Solid-State Circuits, vol. SC-
17, n 3, June 1982, pp. 614-619**

(73) Proprietor: **International Business Machines
Corporation
Old Orchard Road
Armonk, N.Y. 10504(US)**

(72) Inventor: **Ling, Daniel Tajen
49 Amber Drive
Croton-on-Hudson New-York 10520(US)**
Inventor: **Oklobdzija, Vojin G
Victor Lane
Carmel New-York 10512(US)**
Inventor: **Raver, Norman
2281 Sultana Drive
Yorktown Heights New-York 10598(US)**

(74) Representative: **Bailey, Geoffrey Alan
IBM United Kingdom Limited Intellectual
Property Department Hursley Park
Winchester Hampshire SO21 2JN(GB)**

## Description

The invention relates generally to logic circuits. In particular, the invention relates to a method for consistently precharging the nodes of a dynamic logic circuit and a precharge circuit for performing said method.

## Background

A recently developed technology for logic circuits is called alternatively a cascode voltage switch (CVS) or CMOS domino circuit. An early description of this type of circuit appears in a technical article by Krambeck et al., entitled "High-Speed Compact Circuits with CMOS" and appearing in IEEE Journal of Solid-State Circuits, volume SC-17, No.3, June 19, 1982 at pp 614-619. A similar circuit is disclosed by Booher in US-A-3,601,627. The overall structure of a generalised but exemplary CVS circuit is shown in Figure 1. An input register 10 provides a plurality of primary inputs of which in this example eight $PI_1$-$PI_8$, are explicitly shown. There are generally a plurality of logic modules $f_1$-$f_7$, each consisting of a group of logic transistors, having one or more inputs $X_i$ and followed by an inverter. The inputs $X_i$ of each logic group f are either taken from the primary inputs $PI_1$ - $PI_8$ or from the output of the inverter of a logic group f of a previous stage. Selected outputs, three $Y_1$ - $Y_3$ are shown in the example, are led to an output register 12. The complemented output of a logic group f and the following inverter follow from the usual implementations of the logic group f.

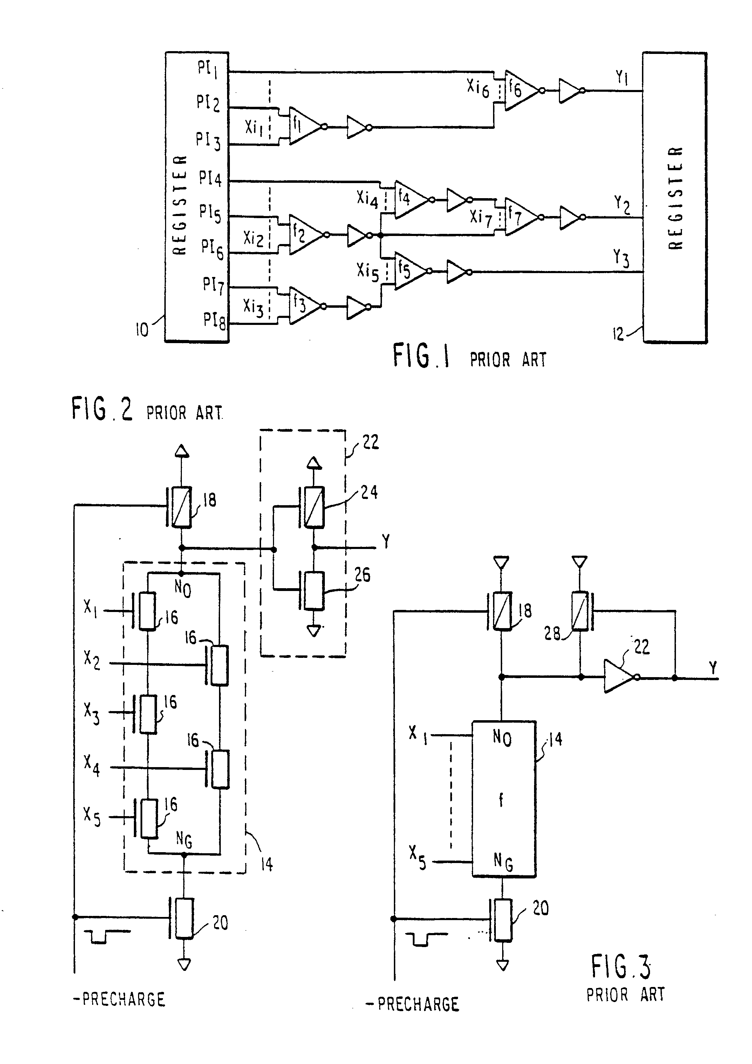

A relatively simple logic group 14 is shown in Figure 2 and is implemented with five n-channel field effect transistors 16 each having a gate input $X_1$-$X_5$. The function implemented is -OR(AND($X_1$, $X_3$, $X_5$), AND ($X_2$, $X_4$)). This logic group 14 is presented for sake of example and much more complicated logic groups are possible. A signal node $N_0$ of the logic group 14 is connected to a power supply (not shown) through an upper precharge p-channel transistor 18. A grounding node $N_g$ of the logic group 14 is connected to ground potential (not shown) through a lower precharge n-channel transistor 20. In a precharge period, the inputs ($X1$-$X5$) are held low so that all the n-channel transistors 16 are turned OFF, that is, made non-conducting. When thereafter a precharge signal (-PRECHARGE) applied to the gate electrodes of transistors 18 and 20 goes low, p-channel transistor 18 is turned ON and n-channel transistor 20 is turned OFF. This isolates the grounding node $N_G$ of the logic group 14 from ground potential but connects the signal node $N_0$ to the power supply voltage. As a result, the signal node $N_0$ is charged during the precharge period to the supply voltage.

The signal node $N_0$ is further connected to the input of a CMOS inverter gate 22 consisting of a p-channel transistor 24 and an n-channel transistor 26 serially connected between the power supply voltage and ground potential of the circuits. The inverter input connects node $N_0$ to the gate electrodes of transistors 24 and 26 and an inverter output Y is taken from the common connection between the two transistors 24 and 26. It should be noted that since at the end of the precharge period, the signal on the signal node $N_0$ is high, the signal on inverter output Y is low. Since the output signal Y may be further connected as an input signal $X_i$ to another logic group the low level on the output Y following precharging of its input logic group is consistent with the requirement that all the input to a subsequent logic group must be at a low level during precharging of this group. The primary inputs Pi to the circuit from register 10 are required to follow this same convention by means of appropriate interface circuits.

At the end of the precharge period, the (-PRECHARGE) signal returns to its high level and transistor 20 turns ON and transistor 18 turns OFF. The grounding node $N_G$ is therefore reconnected to ground but the signal node $N_0$ is isolated from the power supply and left floating with the precharge. The primary inputs $PI_1$ - $PI_8$ from input register 10 then assume their signal values and are applied during an evaluation phase as input to the various logic modules f with the result that low impedance paths are established through some modules and not through others depending upon the levels of inputs signals Xi selectively applied thereto.

If in the present example of a logic module or group shown in Fig.2, a low impedance discharge path from the signal node $N_0$ to the grounding $N_G$ is formed by an appropriate combination of input signals $X_1$ -$X_5$, then the precharged voltage node $N_0$ is discharged through the logic group to a low state. This new low state then switches the CMOS inverter 22 and the output signal Y goes high. If, on the other hand, no discharge path is created, then the output signal Y remains high. The output signal Y may be applied as an input to a logic group of a further precharged stage and, may thus cause a corresponding node of that logic group to discharge and so on through the circuit. Hence, the name domino.

As described, a CVS circuit is dynamic in that it required the precharging of the signal node $N_0$ and the subsequent monitoring of the signal on that signal node $N_0$, to determine whether it continues to be precharged or is discharged through its associated logic group. As with most dynamic circuits, there is a problem associated with the leakage and fluctuation of the precharge from the signal node $N_0$. Leakage in a dynamic circuit is a pervasive problem and several solutions have been proposed. For example, see US-A-4,433,257 (Kinoshita), US-A-3,989,955, US-A-4,464,587 (Suzuki) and US-A-4,398,270 (Taylor)

One method used to reduce the leakage problem is illustrated in Fig.3. Here a p-channel transistor 28 is connected as a feed-back device between the output and input of the inverter 22 and the power supply. The gate electrode of transistor 28 is connected to the output Y of the inverter 22. Thus, when the signal node $N_0$ is charged or high, the output signal Y is low, transistor 28 turns ON thus closing the feedback path and solidly connecting the signal node $N_0$ to the power supply voltage. As a result, any leakage from the signal node $N_0$ is compensated. However, the feedback arrangement needs to be sufficiently weak such that when the signal node $N_0$ is positively discharged, transistor 28 does not continue to feed sufficient charge to the inverter 22 to prevent its output signal Y from turning off the transistor 28.

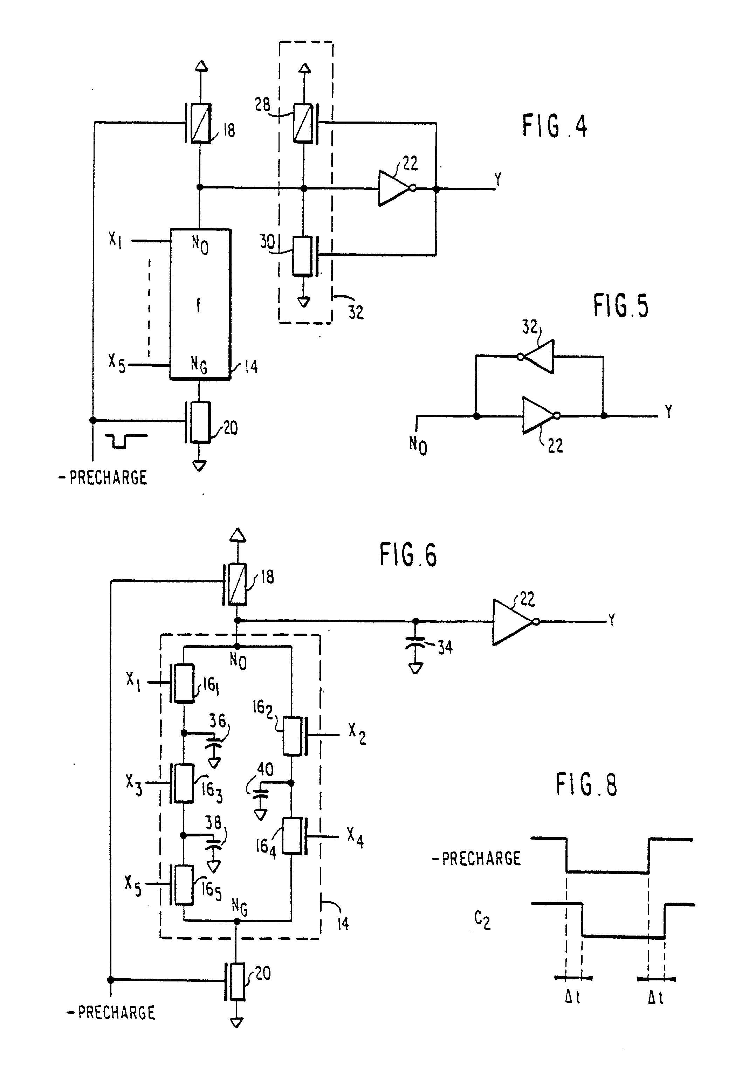

A yet more elaborate feedback is illustrated in Fig.4, in which additionally an n-channel feedback transistor 30 is connected as a feed-back device between the output and input of the inverter 22 and ground potential. The gate electrode of transistor 30 is connected to the output Y of the inverter 22. Now, when the signal on the signal node $N_0$ is discharged or low, the output Y rises, transistor 28 turns OFF, transistor 30 turns ON and solidly connects the signal node $N_0$ and the input of the inverter 22 to ground potential. Thus charge fluctuations and leakage into the signal node $N_0$ are compensated for. Similarly to the p-channel feedback arrangement, the n-channel feedback arrangement needs to be sufficiently weak so that its effect can be overcome by a subsequent positive charging of the signal node $N_0$. Together, the feedback transistors 28 and 30 themselves comprise a weak feedback inverter 32, and are illustrated in block form in Fig.5. The two back-to-back inverters 22 and 32 thus act as a regenerative memory for storing any strong signal impressed upon the signal node $N_0$.

CVS circuits have many advantages but the technology appears to be plagued with spurious signals or glitches. The signal on the signal node $N_0$ is subject to fluctuations, particularly at the beginning of the evaluation phase. The feedback arrangements described above and illustrated in Figures 3 and 4, are aimed at reducing the effects of these fluctuations. However, in a dynamic circuit, the feedback must be weak for circuit to operate and may not be sufficient to prevent the situation arising where an output signal Y varies momentarily to an incorrect high value. Even if the feedback arrangements subsequently bring the output signal Y to the correct low value, the damage may have already been done in that the transient incorrect value may have already discharged the logic group f of a subsequent stage. Thus, the feedback arrangements alone are inadequate to solve the problem.

## Summary of the Invention

Accordingly, an object of this invention is to provide a cascode voltage switching circuit that has reduced susceptibility to internal noise.

A further object of this invention is to reduce the fluctuations without an undue increase in the complexity of the circuit.

Viewed from one aspect the invention provides a method of precharging a cascode voltage network having at least one gate group each comprising one or more logic gates connected between a voltage node and grounding node, and having an output node carrying a signal derived from said voltage node, each said logic gate being controlled by an input signal from a primary input or from an output node of another gate, said method being characterised by the steps of holding said input signals at their potential levels prior to precharging, precharging both said voltage and grounding nodes of each of said gate groups to a first potential level, and changing said input signals to turn off all said logic gates at the end of precharging.

At the beginning of precharging, a pass transistor between the logic gate and the output inverter is turned OFF, thus isolating the output from the precharging voltage. Both the signal node and the grounding node are then precharged. The continued application of the previously derived output signals to the logic groups during this precharging ensures that all internal capacitive nodes which had been discharged in the previous cycle are fully precharged in the current precharging period.

Viewed from another aspect, the invention provides a precharge circuit for performing the method of precharging as described above for a logic block (xi) containing one or more gate devices connected between first and second nodes ($N_o$ and $N_g$) and having input means for cyclically applying combinations of bi-level input signals ($P_1$-$P_8$) to control inputs ($X_1$-$X_5$) of said gates in order to open or close the gates in accordance with the combination of input signals applied during each cycle, said circuit comprising a first switch connecting said first node to a first value reference potential (supply) operable during pre-charge phase of a cycle to charge the first node to the first reference potential, and further comprising a second switch operable during a subsequent evaluation phase of the same cycle, with a selected combination of bi-level input signals applied to said logic block, to connect the second node to the second reference potential (ground) whereby if, as a result of the applied input signals, a conducting path is established through said logic block, current flows through the logic block with a consequential change in potential of said first node to said second reference potential, and output means for detecting such change characterised by means for maintaining the same combination of input signals applied to said logic block as were applied during the evaluation phase of the immediately preceding cycle during the start of the pre-charge phase of a current cycle, means for changing the input signals as appropriate so that all gates within the logic block are turned off before the end of the current pre-charge phase, and a third switch operable during said pre-charge phase to connect said second node to the first reference potential.

Brief Description of the Drawings

Figure 1 is a simplified schematic of an exemplary cascode voltage switch circuit.

Figure 2 is a schematic illustration of a module in a CVS circuit.

Figures 3 and 4 are improvements of the circuit of Figure 2, utilising feedback.

Figure 5 is a schematic diagram illustrating the feedback memory of Figure 4.

Figure 6 is a schematic illustration of the precharging points of the circuit of Figure 2.

Figure 7 is a schematic illustration of one embodiment of the present invention.

Figure 8 is a timing diagram for the circuit of Figure 7.

Figure 9 and 10 are alternative memory units for the circuit of Figure 7.

Detailed Description of The Preferred Embodiments

The inventors believe that a major cause of the signal fluctuations in cascode voltage switch (CVS) circuits arises from redistribution of the precharge dependent upon the signal inputs of the prior evaluation phase. This effect will be explained with reference to Figure 6, which illustrates some details omitted from Figure 2. The precharging of the signal node $N_0$ implies that there is a substantial capacitance 34 associated with that node. In MOS technology, there is often enough parasitic capacitance associated with the long interconnections between the signal node $N_0$, the upper precharge transistor 18, and the inverter 22 so that the capacitance 34 does not need to be separately provided. In the precharging phase, the capacitance 34 is positively charged and is discharged in the evaluation phase if a conducting path is formed through the logic group 14 to ground.

However, the capacitance 34 is not the only parasitic capacitance in the circuits. There is additional capacitance 36, 38 and 40 at the points between the logic gates 16. However, according to the design convention for CVS circuits, all the inputs $X_1$-$X_5$ are low during the precharging period so that the associated transistors $16_1$-$16_5$ are turned off during precharging. As a result, the parasitic capacitances 36-40 within the logic group 14 are not accessible and are not precharged. For the most part, the amount of charge on the capacitances 36-40 within a logic group at the end of the precharging period is determined by the amount to which they were charged at the end of the prior evaluation period. This amount of charge, in turn, is determined by the values of the input signals $X_1$-$X_5$ to the current logic group which were applied in the prior evaluation period. For example, assuming that the internal capacitance 36-40 were fully charged before the prior evaluation period, then if all the input signals $X_1$-$X_5$ were low (binary '0') in the prior evaluation period, the internal capacitance 36-38 remain fully charged for the current evaluation period. If, on the other hand, all the input signal $X_1$-$X_5$ in the prior evaluation period were high (binary 1), then all the internal capacitances 36-40 of the group will have been discharded. Furthermore, different combinations of input signals $X_1$-$X_5$ in the prior evaluation phase can cause different combinations of the internal capacitances 36-40 to be discharged. The importance of precharging inherent capacitance has been discussed in US-A-3,778,782 (Kitagawa) and in US-A-4,200,917 (Moench).

In order to understand the effect of the varying value of the internal capacitances the different situations will be considered in some detail. In the subsequent evaluation phase of a logic group following precharging, the precharge on the signal node $N_0$, that is, the precharge on the capacitance 34, may be discharged to ground if the input signals $X_1$-$X_5$ turn on sufficient transistors 16 to form a conducting path to ground. In this case, the precharge on the signal node $N_0$ is discharged to ground through the conducting path of transistors, although the transition time may depend upon the amount of charge on the internal capacitances 36-40. If the input signals $X_1$ and $X_2$ are low during the evaluation phase, then all the precharge remains on the signal node $N_0$ and a solid high signal is presented to the inverter 22. The real problem arises when the combination of inputs $X_1$-$X_5$ are such as not to form a conducting path to discharge the node $N_0$ but nonetheless one or more of the transistors adjacent the node $N_0$, such as transistors $16_1$ or $16_2$ are ON. As a result, the capacitance 36 or 40 or possibly both are put in parallel with the capacitance 34.

If the internal capacitance 36 or 40 remains charged following the previous evaluation phase, then the problem should be relatively small because all the capacitances have been charged by similar voltages. However, if the internal capacitance 36 or 40 has been discharged in the prior evaluation phase, then the precharge on the capacitance 34 is redistributed to the discharged capacitance 36 or 40 or possibly both. This redistribution of the precharge causes the voltage on the signal node $N_0$ to dip. The amount of this dip is thus dependent upon the input signals $X_1$-$X_5$ of the prior evaluation phase as well as the input signals $X_1$-$X_5$ of the current evaluation phase, and thus is difficult to predict or control.

The feedback around the inverter 22, as shown in either Figures 3 or 4, can compensate for this dip and bring the signal on the signal node $N_0$ back up to a solid high as long as the dip is not too severe. However, as previously mentioned, the feedback must be weak so that a transient dip appears inevitable in view of the dynamic nature of a CVS circuit. It is possible that the feedback eventually brings the high signal on the signal node $N_0$ back to its correct value, but, in the meantime, the output signal Y may have changed enough to have caused a logic group f of the following stage to have discharged. Once this following logic group has been discharged, the application of the correct input signals to that stage, intended to keep that logic group charged, cannot recharge the signal node $N_0$ of the following group. As a result, transient signal errors become permanent by the domino nature of a CVS circuit.

The invention uses this understanding of the problem to reduce fluctuations by the following method. The output signal Y is memorised and then held during a part of the precharging period at the level it had in the prior evaluation phase. That is before the current precharging period. Then whilst the value is held, both the signal node $N_0$ and the ground node $N_G$ of the logic group are both precharged. Since precharging of all the logic units is conducted simultaneously, the inputs $X_i$ to all the logic groups are held at the values of the previous evaluation phase. However, as will be seen the inputs $X_i$ are forced to the low level before the end of the precharge phase as is required.

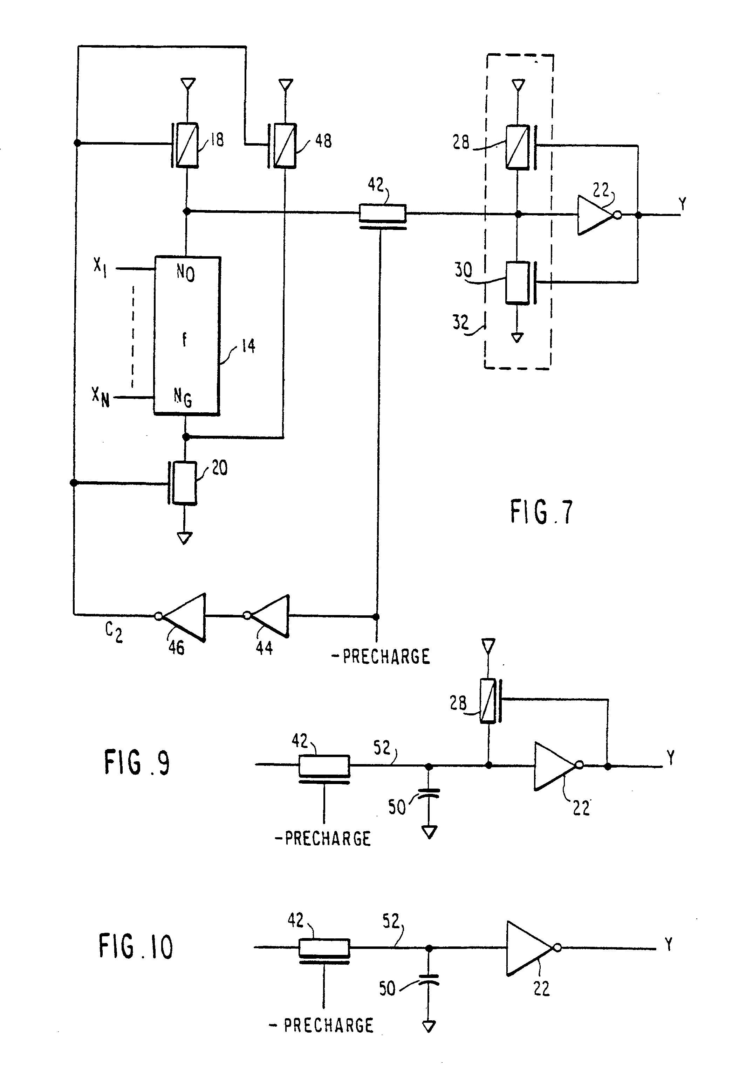

The implementation for the CVS module of Figure 4 is shown in Figure 7. A (-PRECHARGE) signal, having a slightly different function than the (-PRECHARGE) of Figures 2 and 6, directly controls the gate of an n-channel pass transistor 42 connecting the signal node $N_0$ to the input to the inverter 22. Thus, at the beginning of the precharge period, with (-PRECHARGE) signal low, transistor 42 is turned OFF and the signal node $N_0$ is isolated

from the inverter 22 and the weak feedback inverter 32. As previously mentioned, the combination of the inverters 22 and 32 act as a memory device. With the memory device thus isolated from the precharging, the value of the output signal Y of the prior evaluation phase is held during the current precharging period. This condition applies to the output of all CVS modules.

The (-PRECHARGE) signal is passed, as shown in Figure 8, through two inverters 44 and 46, to form a delayed precharged signal on line $C_2$ which is applied to the upper and lower precharge transistors 18 and 20 in the usual way and additionally to a further precharge p-channel transistor 48 connected between the power supply and the grounding node $N_G$ of the logic group 14. The delayed low level of the (-PRECHARGE) signal turns transistor 20 OFF and transistors 18 and 48 ON. As a result, following the downward transition of the delayed (-PRECHARGE) signal on line $C_2$, the signal node $N_0$ having been previously isolated from the inverters 22 and 32 to which it is normally connected is then connected to the power supply via the transistor 18 for precharging. At the same time, the grounding node $N_G$ is isolated from ground by the transistor 20 turning OFF and itself connected to the power supply for precharging via the transistor 48. Thus, both nodes $N_0$ and $N_G$ of the logic group 14 are precharged to the supply voltage. During this delayed precharging period, the input signals $X_1$-$X_N$ are held at their respective values of the prior evaluation phase by memory units of other logic modules corresponding to the inverters 22 and 32. Primary inputs to the CVS circuits must follow the same convention which could be accomplished by attaching a pass gate 42 and inverters 22 and 32 to the primary inputs $PI_i$.

In summary, certain combinations of input signals $X_i$ of the prior evaluation phase caused certain of the transistor 16 to turn ON and thus discharge their associated internal capacitances 36-40. The discharging could either have been directly downward to the grounding node $N_G$ or could have first followed an upward path to the signal node $N_0$ before reversing to a fully conductive path to the grounding node $N_G$. In some types of CVS circuits, it may be possible that more complex discharging paths are formed. Thus, whatever discharging paths to the nodes $N_0$ and $N_G$ were formed during the prior evaluation phase are also maintained at least for a period in the current precharging. However, both of the nodes $N_0$ and $N_G$ are held at the precharging voltage during precharging so that whatever internal capacitances 36-40 were discharged during the prior evaluation are once again precharged. The precharging of all capacitances is to the same supply power voltage.

The relative timing of the (-PRECHARGE) signal and the delayed (-PRECHARGE) signal on line $C_2$ is shown in Figure 8. The important point is that the delay is substantially less than the duration of either pulse. A value of 600 ps for $\Delta t$ would be reasonable although its best value depends on the rest of the circuit.

When the (-PRECHARGE) signal goes high, the first occurrence is for the pass transistor 42, to be turned ON. Immediately, the precharge now existing on the signal node $N_0$ forces the output signal Y to a low level. As a result, all the input signals Xi go to a low level because the same convention is applied to these inputs. Thus all the transistors 16 in all logic groups such as the logic group 14 are turned OFF for the last part of the precharging phase by the delayed signal precharge signal still on line $C_2$. This prevents a memorised conducting path through a logic group from erroneously discharging the precharged signal node $N_0$ if the various transitions are not timed exactly. Finally, after delay $\Delta t$ the delayed (-PRECHARGE) signal on line $C_2$ also goes high to discontinue the precharging process and turn OFF transistors T18 and T48 and turn ON transistor 20 thereby reconnecting the grounding node $N_G$ to the ground potential ready for the subsequent evaluation phase.

Then, following this precharging phase, the application of the current set of the primary inputs PI$_i$ will initiate the domino effect upon fully precharged logic groups 14. The internal capacitances 36-40 have been precharged to the same voltage as the capacitance 34. As a result, there is no redistribution of precharge.

The circuit of Figure 7 shows that the delayed precharge signal on line $C_2$ is generated locally, that is, in the neighbourhood of the logic group 14, directly from the (-PRECHARGE) signal. This approach necessitates two additional inverters 44 and 46 for each logic group 14. It is possible for both the precharge signal (-PRECHARGE) and the delayed version on line $C_2$ to be generated at one point on an integrated circuit and then both to be distributed to all of the logic groups 14 on the integrated circuit. This central generation of both precharging signals of course necessitates additional interconnections. However, the routing for both sets of interconnections can be the same so that the complexity is not greatly increased. Furthermore, if the two interconnections are routed in parallel, any time skew affecting one of the precharging signal affects the other. As a result, the amount of delay $\Delta t$ is easily maintained over the long interconnections.

The embodiment shown in Figure 7 used two back-to-back inverters 22 and 32 as a fully regenerative memory unit. However, it should be remembered that there is some associated parasitic capacitance 50, as shown in Figure 9, on the interconnection 52 between the pass transistor 42 and the inverter 22. Furthermore, the main leakage associated with this interconnection 52 is to ground. That is, the capacitance 50, for the most part, adequately holds a low signal but is somewhat undependable for a high or charged signal. Accordingly, the feedback gate 30 connected between the interconnection 52 and ground in the prior art circuit can be dispensed with. The required memory function can be adequately fulfilled by the p-channel feedback transistor 28, the capacitance 50 and the inverter 22.

It is also possible, as shown in Figure 10, to completely dispense with both feedback transistors in the memory unit since the capacitor 50 itself is an adequate memory unit. Admittedly, it is somewhat leaky, particularly for high level signals but as long as the capacitance 50 is required to memorise the signal only for a time shorter than its leakage time, it alone is satisfactory. The leakage time can be lengthened by intentionally including a large capacitance 50 that has relatively low leakage compared to that of the interconnection 52. Nonetheless, the capacitor 50 and the interconnection 52 do leak so that the circuit of Figure 10 is dynamic. As a result, there will be a minimum operating frequency between the precharging periods to ensure that the memory unit of Figure 10 does not decay to an incorrect value. In the embodiments of Figures 9 and 10, it is of course assumed that the rest of the circuit of Figure 7 is maintained.

**Claims**

1.   A method of precharging a cascode voltage network having at least one gate group each comprising one or more logic gates connected between a voltage node and grounding node, and having an output node carrying a signal derived from said voltage node, each said logic gate being controlled by an input signal from a primary input or from an output node of another gate, said method being characterised by the steps of:

holding said input signals at their potential levels prior to precharging,

precharging both said voltage and grounding nodes of each of said gate groups to a first potential level, and

changing said input signals to turn off all said logic gates at the end of precharging.

2.   A precharge circuit for performing the method of precharging as claimed in claim 1 for a logic block (xi) containing one or more gate devices (161-165) connected between first and second nodes ($N_o$ and $N_g$) and having input means for cyclically applying combinations of bi-level input signals ($P_1$-$P_8$) to control inputs ($X_1$-$X_5$) of said gates in order to open or close the gates in accordance with the combination of input signals applied during each cycle, said circuit comprising a first switch (18) connecting said first node to a first value reference potential (supply) operable during pre-charge phase of a cycle to charge the first node to the first reference potential, and further comprising a second (20) switch operable during a subsequent evaluation phase of the same cycle, with a selected combination of bi-level input signals applied to said logic block, to connect the second node to the second reference potential (ground) whereby if, as a result of the applied input signals, a conducting path is established through said logic block, current flows through the logic block with a consequential change in potential of said first node to said second reference potential, and output means (22) for detecting such change characterised by means for maintaining the same combination of input signals applied to said logic block as were applied during the evaluation phase of the immediately preceding cycle during the start of the pre-charge phase of a current cycle, means for changing the input signals as appropriate so that all gates within the logic block are turned off before the end of the current pre-charge phase, and a third switch (48) operable during said pre-charge phase to connect said second node to the first reference potential.

3. A precharge circuit as claimed in claim 2, in which said output means includes an output circuit (22) operable in response to potential changes of said first node to generate bi-level output signals, one level output signal indicating that the first node is at the first potential and the other level indicating that the first node is at the second potential, said output means further comprising a fourth switch (42) connected between the first node and the output circuit and operable to disconnect the output circuit from the first node for a predetermined period, said period commencing immediately prior to the start of a precharge phase of the associated logic block but being re-connected before the end of the precharge phase, said output circuit including memory means sufficient to maintain the integrity of the current output signal level of the output circuit during the period of isolation from said first node.

4. A logic network comprising a plurality of logic blocks associated output circuits as claimed in claim 3, the input signals to the logic blocks being supplied from the outputs of a loadable input register (10) or from the output of a preceding logic block circuit, the output signal from the output circuits being supplied to the input stages of an output register (12) or to control inputs of a succeeding logic block circuit.

5. A precharge circuit as claimed in claim 3, in which said first and third switches are MOS transistors of one conductivity type and said second and fourth switches are MOS transistors of the opposite conductivity type, and including control means to supply a bi-level control signal to the gates of said transistors whereby when the control signal is at one level the MOS transistors of one conductivity type are switched ON and when the control signal is at the other level, the MOS transistors of the opposite conductivity type are switched ON, the arrangement being such that the control signal applied to the gate of said fourth transistor is shifted in time with respect to the corresponding control signal applied to said first second and third transistors such that the signal level causing said fourth transistor to switch off occurs in advance of the corresponding signal level causing the second transistor to switch off and the first and third transistor to switch on, and consequently the signal level causing the fourth transistor to switch ON occurs in advance of the corresponding signal level causing the second transistor to switch ON and the first and third transistors to switch OFF.

6. A precharge circuit as claimed in claim 5, in which the first reference potential is the supply potential, the second reference potential is ground potential, the first and third transistors are p-channel devices and the second and fourth transistors are n-channel devices, and in which the bi-level control signal is applied directly to the gate electrode of the fourth transistor and via a delay (44, 46), small with respect to the pulse length of the bi-level signal, the gate electrode of the first, second and third transistors.

7. A precharge circuit as claimed in claim 6, in which the gates comprising a logic block consists of n-channel MOS transistors and the output circuit operates to produce at its output a signal level the inverse of the signal level on said first node whereby a high level signal on the output indicates that the applied combination of input signals to said logic block during an evaluation phase has matched the internal logic representation of said block.

8. A precharge circuit as claimed in claim 7, in which said output circuit incorporating memory comprises a first buffer amplifier (22) having an input connected to the fourth transistor and a second buffer amplifier (32) being weaker than said first buffer amplifier and having its output connected to the output of said fourth transistor and having its input connected to the output of said first buffer amplifier which is also the output (Y) of the circuit.

9. A precharge circuit as claimed in claim 8, in which said second buffer amplifier consists of an MOS transistor (28 or 30) connected between the output of said fourth transistor and one or other of said first or second reference potentials and its gate electrode connected directly to the output of said first buffer amplifier.

## Revendications

1. Méthode deprécharge d'un réseau de tension cascode ayant au moins un groupe de portes, chaque groupe comprenant une ou plusieurs portes logiques connectées entre un noeud de tension et un noeud de mise à la terre, et ayant un noeud de sortie qui porte un signal dérivé du dit noeud de tension, chaque dite porte logique étantcommandée par un signal d'entrée provenant d'une entrée primaire ou d'un noeud de sortie d'une autre porte, ladite méthode étant caractérisée par les étapes de :
maintien desdits signaux d'entrée à leurs niveaux de potentiel antérieurs à la précharge,
précharge à la fois des noeuds de tension et de mise à la terre de chacun desdits groupes de portes à un premier niveau de potentiel, et
changement desdits signaux d'entrée pour couper toutes les dites portes logiques à la fin de la précharge.

2. Circuit de précharge pour la mise en oeuvre de la méthode de précharge suivant la revendication 1, pour un bloc logique (Xi) contenant une ou plusieurs portes ($16_1$-$16_5$) connectées entre un premier et un deuxième noeuds ($N_O$ et $N_G$) et comportant des moyens d'entrée pour appliquer cycliquement des combinaisons de signaux d'entrée biniveaux ($P_1$-$P_8$) aux entrées de commande ($X_1$ - $X_5$) des dites portes afin d'ouvrir ou fermer les portes conformément à la combinaison des signaux d'entrée appliqués pendant chaque cycle, ledit circuit comprenant un premier commutateur (18) connectant le dit premier noeud à un potentiel de référence d'une première valeur (alimentation)qui agit pendant la phase de précharge d'un cycle pour charger le premier noeud au premier potentiel de référence, et comprenant en outre un deuxième commutateur (20) qui agit pendant une phase d'évaluation subséquente du même cycle, avec une combinaison choisie de signaux d'entrée biniveaux appliqués audit bloc logique, pour connecter le deuxième noeud au deuxième potentiel de référence (terre) de sorte que si, comme résultat des signaux d'entrée appliqués, un chemin conducteur est établi à travers ledit bloc logique, un courant circule à travers le bloc logique avec un changement résultant du potentiel dudit premier noeud audit deuxième potentiel de référence, et des moyens de sortie (22) pour détecter ce changement, caractérisé par des moyens de maintien de la même combinaison de signaux d'entrée appliquée audit bloc logique que celle qui était appliquée pendant la phase d'évaluation du cycle immédiatement précédent, au début de la phase de précharge d'un cycle en cours, des moyens de changement des signaux d'entrée de façon appropriée pour que toutes les portes dans le bloc logique soient rendues non conductrices avant la fin de la phase deprécharge en cours, et un troisième commutateur (48) qui agit pendant ladite phase de précharge pour connecter ledit deuxième noeud au premier potentiel de référence.

3. Circuit de précharge suivant la revendication 2, dans lequel lesdits moyens de sortie comprennent un circuit de sortie (22) qui agit, en réponse aux changements de potentiel dudit premier noeud, pour engendrer des signaux de sortie biniveaux, un niveau du signal de sortie indiquant que le premier noeud est au premier potentiel et l'autre niveau indiquant que le premier noeud est au deuxième potentiel, lesdits moyens de sortie comprenant en outre un quatrième commutateur (42) connecté entre le premier noeud et le circuit de sortie et qui agit pour déconnecter le circuit de sortie du premier noeud pendant une période prédéterminée, ladite période commençant immédiatement avant le début d'une phase de précharge du bloc logique associé,mais pour le reconnecter avant la fin de la phase de précharge, ledit circuit de sortie comprenant des moyens de mémoire suffisants pour maintenir l'intégrité du niveau de signal de sortie en cours du circuit de sortie pendant la période d'isolation par rapport audit premier noeud.

4. Réseau logique comprenant une pluralité de blocs logiques et de circuits de sortie associés suivant la revendication 3, les signaux d'entrée aux blocs logiques étant fournis par les sorties d'un registre d'entrée à chargement (10) ou par la sortie d'un circuit de bloc logique précédent, le signal de sortie des circuits de sortie étant fourni aux étages d'entrée d'un registre de sortie (12) ou aux entrées de commande d'un circuit de bloc logique suivant.

5. Circuit de précharge suivant la revendication 3, dans lequel lesdits premier et troisième commutateurs sont des transistors MOS d'un premier type de conductivité et lesdits deuxième et quatrième commutateurs sont des transistors MOS du type de conductivité opposé, et comprenant des moyens de commande pour appliquer un signal de commande biniveau aux grilles desdits transistors de sorte que,lorsque le signal de commande est à un premier niveau, les transistors MOS d'un premier type de conductivité sont mis en conduction et, lorsque le signal de commande est à l'autre niveau, les transistors MOS du type de conductivité opposé sont mis en conduction, l'agencement étant tel que le signal de commande appliqué à la grille dudit quatrième transistor est décalé en temps par rapport au signal de commande correspondant appliqué auxdits premier, deuxième et troisième transistors, de sorte que le niveau de signal provoquant le passage dudit quatrième transistor en non conduction se produit avant le niveau de signal correspondant provoquant le passage du deuxième transistor en non conduction et le passage des premier et troisième transistors en conduction, et par conséquent le niveau de signal provoquant le passage du quatrième transistor en conduction se produit avant le niveau de signal correspondant provoquant le passage du deuxième transistor en conduction et le passage des premier et troisième transistors en non conduction.

6. Circuit de précharge suivant la revendication 5, dans lequel le premier potentiel de référence est le potentiel d'alimentation, le deuxième potentiel de référence est le potentiel de terre, les premier et troisième transistors sont des dispositifs à canal p et les deuxième et quatrième transistors sont des dispositifs à canal n, et dans lequel le signal de commande biniveau est appliqué directement à l'électrode de grille du quatrième transistor et par l'intermédiaire d'une temporisation (44,46), petite par rapport à la longueur d'impulsion du signal biniveau, à l'électrode de grille des premier, deuxième et troisième transistors.

7. Circuit de précharge suivant la revendication 6, dans lequel les portes constituant un bloc logique sont des transistors MOS à canal n et le circuit de sortie fonctionne pour produire, à sa sortie, un niveau de signal qui est l'inverse du niveau de signal audit premier noeud, de sorte qu'un signal de niveau haut à la sortie indique que la combinaison de signaux d'entrée appliquée audit bloc logique pendant une phase d'évaluation a concordé avec la représentation logique interne dudit bloc.

8. Circuit de précharge suivant la revendication 7, dans lequel ledit circuit de sortie incorporant une mémoire comprend un premier amplificateur en tampon (22), dont une entrée est connectée au quatrième transistor, et un deuxième amplificateur en tampon (32) plus faible que ledit premier amplificateur en tampon et dont la sortie est connectée à la sortie dudit quatrième transistor et dont l'entrée est connectée à la sortie dudit premier amplificateur en tampon qui est également la sortie (Y) du circuit.

9. Circuit de précharge suivant la revendication 8, dans lequel ledit deuxième amplificateur en tampon consiste en un transistor MOS (28 ou 30) connecté entre la sortie dudit quatrième transistor et l'un ou l'autre desdits premier ou deuxième potentiels de référence, son électrode de grille étant connectée directement à la sortie dudit premier amplificateur en tampon.

## Patentansprüche

1. Verfahren zum Vorladen eines Cascodespannungsnetzwerkes die zumindest eine Tor-Gruppe besitzt, wobei jede ein oder mehrere Logik-Tore aufweist, die zwischen einen Spannungsknoten und einen Erdungsknoten geschaltet sind und mit einem Ausgangsknoten, der ein aus dem Spannungsknoten abgeleitetes Signal führt, wobei jedes Logik-Tor durch ein Eingangssignal aus einem primären Eingang oder aus einem Ausgangsknoten eines anderen Tores gesteuert wird, wobei das Verfahren durch die folgenden Schritte gekennzeichnet ist:

Halten der Eingangssignale auf ihren Potentialpegeln vor dem Vorladen,

Vorladen sowohl der Spannungs- als auch der Erdungsknoten jeder der Tor-Gruppen zu einem ersten Potentialpegel und

Ändern der Eingangssignale, um alle Logik-Tore an dem Ende des Vorladens auszuschalten.

2. Schaltung zum Vorladen zum Durchführen des Verfahrens zum Vorladen nach Anspruch 1 für einen Logikblock (xi) der ein oder mehrere Tor-Bauelemente (161-165) enthält, die zwischen erste und zweite Knoten ($N_o$ und $N_g$) geschaltet sind und mit Eingangsmitteln zum zyklischen Anlegen von Kombinationen von Zwei-Pegel-Eingangssignalen ($P_1$-$P_8$) zum Steuern von Eingängen ($X_1$-$X_5$) der Tore, um die Tore entsprechend der Kombination während jedes Zyklus angelegter Eingangssignale zu öffnen oder zu schließen, wobei die Schaltung einen ersten Schalter (18) aufweist, welcher den ersten Knoten an ein erstes WertReferenzpotential (Versorgung) anlegt, wobei er während einer Vor-Lade-Phase eines Zyklus zum Laden des ersten Knoten zu dem ersten Referenzpotential betrieben werden kann, und ferner einen zweiten (20) Schalter aufweist, der während einer nachfolgenden Auswertungsphase desselben Zyklus mit einer an den Logikblock angelegten ausgewählten Kombination von ZweiPegel-Eingangssignalen betrieben werden kann, um den zweiten Knoten an das zweite Referenzpotential (Erde) zu legen, wodurch ein Strom durch den Logikblock mit einer folgenden Änderung des Potentials des ersten Knotens auf das zweite Referenzpotential fließt, falls ein leitender Pfad durch den Logikblock infolge der angelegten Eingangssignale hergestellt wird, und mit einem Ausgangsmittel (22) zum Erfassen einer solchen Änderung, gekennzeichnet durch Mittel zum Aufrechterhalten derselben Kombination von an den Logikblock angelegten Eingangssignalen, wie sie während der Auswertungsphase des unmittelbar vorangehenden Zyklus während der Ingangsetzung der Vor-Lade-Phase eines laufenden Zyklus angelegt wurden, Mittel zum Ändern der Eingangssignale auf geeignete Weise so, daß alle Tore innerhalb des Logikblocks vor dem Ende der laufenden Vor-Lade-Phase ausgeschaltet werden und einen dritten Schalter (48), der während der Vor-Lade-Phase betrieben werden kann, um den zweiten Knoten an das erste Referenzpotential zu legen.

3. Schaltung zum Vorladen nach Anspruch 2, bei welcher das Ausgangsmittel eine Ausgangsschaltung (22) aufweist, die entsprechend Potentialänderungen des ersten Knotens betrieben werden kann, um Zwei-Pegel-Ausgangssignale zu erzeugen, wobei ein Pegel-Ausgangssignal anzeigt, daß sich der erste Knoten auf dem ersten Potential befindet und der andere Pegel anzeigt, daß sich der erste Knoten auf dem zweiten Potential befindet, wobei das Ausgangsmittel ferner einen vierten Schalter (42) aufweist, der zwischen den ersten Knoten und die Ausgangsschaltung geschaltet ist und betrieben werden kann, um die Ausgangsschaltung von dem ersten Knoten für eine vorher bestimmte Periode zu trennen, wobei die Periode unmittelbar vor der Ingangsetzung der Vorladephase des zugeordneten Logikblockes beginnt, sie jedoch vor dem Ende der Vorladephase wieder angelegt wird, wobei die Ausgangsschaltung Speichermittel aufweist, die ausreichen, um die Integrität des laufenden Ausgangssignalpegels der Ausgangsschaltung während der Periode einer Trennung von dem ersten Knoten aufrechtzuerhalten.

4. Logik-Netzwerk mit einer Mehrzahl von Logikblöcken zugeordneten Ausgangsschaltungen nach Anspruch 3, wobei die Eingangssignale zu den Logikblöcken von den Ausgängen eines ladbaren Eingangsregisters (10) oder von dem Ausgang einer vorangehenden Logikblockschaltung geliefert werden, wobei das Ausgangssignal von den Ausgangsschaltungen zu den Eingangsstufen eines Ausgangsregisters (12) oder zum Steuern von Eingängen einer nachfolgenden Logikblockschaltung geliefert wird.

5. Schaltung zum Vorladen nach Anspruch 3, bei welcher die ersten und dritten Schalter MOS-Transistoren einer Leitungsart sind und die zweiten und vierten Schalter MOS-Transistoren der ungleichnamigen Leitungsart sind und sie Steuermittel aufweist, um ein Zwei-Pegel-Steuersignal zu den Gate-s der Transistoren zu liefern, wodurch die MOS-Transistoren einer Leitungsart EIN-geschaltet werden, wenn sich das Steuersignal auf einem Pegel befindet und die MOS-Transistoren der ungleichnamigen Leitungsart EIN-geschaltet werden, wenn sich das Steuersignal auf dem anderen Pegel befindet, wobei die Anordnung derart ist, daß das an das Gate des vierten Transistors gelegte Steuersignal zeitlich bezüglich des entsprechenden Steuersignales das an die ersten, zweiten und dritten Transistoren gelegt ist, so verschoben wird, daß der Signalpegel, der bewirkt, daß der vierte Transistor ausschaltet, davor auftritt, daß der entsprechende Signalpegel bewirkt, daß der zweite Transistor ausschaltet und der erste und dritte Transistor einschaltet und folglich, daß der Signalpegel, der bewirkt, daß der vierte Transistor EIN-schaltet davor auftritt, daß der entsprechende Signalpegel bewirkt, daß der zweite Transistor EIN-schaltet und die ersten und dritten Transistoren auf AUS schalten.

6. Schaltung zum Vorladen nach Anspruch 5, bei welcher das erste Referenzpotential das Versorgungspotential ist, das zweite Referenzpotential das Erdungspotential ist, die ersten und dritten Transistoren p-Kanal Bauelemente und die zweiten und vierten Transistoren n-Kanal Bauelemente sind und bei welcher das Zwei-Pegel-Steuersignal unmittelbar an die Gate-Elektrode des vierten Transistors und über eine Verzögerung (44, 46), die bezüglich der Impulslänge des Zwei-Pegel-Signals klein ist, an die Gate-Elektrode der ersten, zweiten und dritten Transistoren geschaltet ist.

7. Schaltung zum Vorladen nach Anspruch 6, bei welcher die einen Logikblock einschließenden Tore aus n-Kanal MOS-Transistoren bestehen und die Ausgangsschaltung arbeitet, um an ihrem Ausgang einen Signalpegel zu erzeugen, der invers zu dem Signalpegel an dem ersten Knoten ist, wodurch ein Hochpegel-Signal an dem Ausgang anzeigt, daß die angelegte Kombination von Eingangssignalen an den Logikblock während der Auswertungsphase zu der internen Logikrepräsentation des Blockes gepaßt hat.

8. Schaltung zum Vorladen nach Anspruch 7, bei welcher die einen Speicher einschließende Ausgangsschaltung einen ersten Pufferverstärker (22) mit einem an den vierten Transistor geschalteten Eingang und einem zweiten Pufferverstärker (32) aufweist, der schwächer als der erste Pufferverstärker ist und sein Ausgang an den Ausgang des vierten Transistors geschaltet ist und sein Eingang an den Ausgang des ersten Pufferverstärkers geschaltet ist, der auch der Ausgang (Y) der Schaltung ist.

9. Schaltung zum Vorladen nach Anspruch 8, bei welcher der zweite Pufferverstärker aus einem MOS-Transistor (28 oder 30) besteht, der zwischen den Ausgang des vierten Transistors und eines oder anderes der ersten oder zweiten Referenzpotentiale geschaltet ist und seine Gate-Elektrode unmittelbar an den Ausgang des ersten Pufferverstärkers geschaltet ist.

FIG.1 PRIOR ART

FIG.2 PRIOR ART

FIG.3 PRIOR ART

-PRECHARGE

-PRECHARGE

EP 0 206 462 B1

FIG.4

FIG.5

FIG.6

FIG.8

13

FIG.7

FIG.9

FIG.10